(19) Europäisches Patentamt
European Patent Office
Office européen des brevets

(11) **EP 1 800 140 B1**

(12) **FASCICULE DE BREVET EUROPEEN**

(45) Date de publication et mention
de la délivrance du brevet:
**08.01.2014 Bulletin 2014/02**

(21) Numéro de dépôt: **05760039.7**

(22) Date de dépôt: **21.04.2005**

(51) Int Cl.:
*G01P 15/097* (2006.01)     *H03H 9/50* (2006.01)

(86) Numéro de dépôt international:
**PCT/FR2005/000988**

(87) Numéro de publication internationale:
**WO 2005/121811 (22.12.2005 Gazette 2005/51)**

(54) **DISPOSITIF DE DÉCOUPLAGE MÉCANIQUE POUR CAPTEUR VIBRANT DIFFÉRENTIEL MONOLITHIQUE**

EINRICHTUNG ZUR MECHANISCHEN ENTKOPPLUNG FÜR EINEN MONOLITHISCHEN DIFFERENZ-VIBRATIONSSENSOR

DEVICE FOR MECHANICAL DECOUPLING FOR MONOLITHIC DIFFERENTIAL VIBRATING SENSOR

(84) Etats contractants désignés:
**CH DE FR GB LI**

(30) Priorité: **05.05.2004 FR 0404794**

(43) Date de publication de la demande:
**27.06.2007 Bulletin 2007/26**

(73) Titulaire: **ONERA (Office National d'Etudes et de Recherches Aérospatiales) 92320 Châtillon (FR)**

(72) Inventeurs:
• **LE TRAON, Olivier**
  **F-91430 Vauhallan (FR)**
• **PERNICE, Marc**
  **F-94260 Fresnes (FR)**
• **JANIAUD, Denis**
  **F-91940 Les Ulis (FR)**
• **LECORRE, Bernard**
  **F-92360 Meudon la Forêt (FR)**
• **MULLER, Serge**
  **F-91470 Forges les Bains (FR)**

(74) Mandataire: **Gevers France
41, avenue de Friedland
75008 Paris (FR)**

(56) Documents cités:
**FR-A- 2 739 190     US-A- 4 216 402**

EP 1 800 140 B1

**Description**

La présente invention concerne, de manière générale, des capteurs vibrants monolithiques fonctionnant en mode différentiel, c'est-à-dire constitués de deux éléments vibrants solidaires d'un même support. Le caractère monolithique est favorable à la réduction du coût de fabrication car il permet d'éviter des assemblages de pièces, et le fonctionnement en mode différentiel vise à améliorer la précision de la mesure en réduisant l'influence des grandeurs d'entrée parasites qui agissent en mode commun sur les deux éléments vibrants.

Plus particulièrement, l'invention a trait à un dispositif permettant de découpler les vibrations mécaniques des deux éléments vibrants afin d'éviter une dégradation de la précision de mesure lorsque les fréquences des deux vibrations sont proches l'une de l'autre.

Par le brevet US-4 216 402, on connaît un dispositif résonateur piézoélectrique de structure intégrée, comprenant un résonateur central qui est relié à un cadre par l'intermédiaire de deux bras opposés. Les deux bras sont positionnés dans des zones particulières du résonateur.

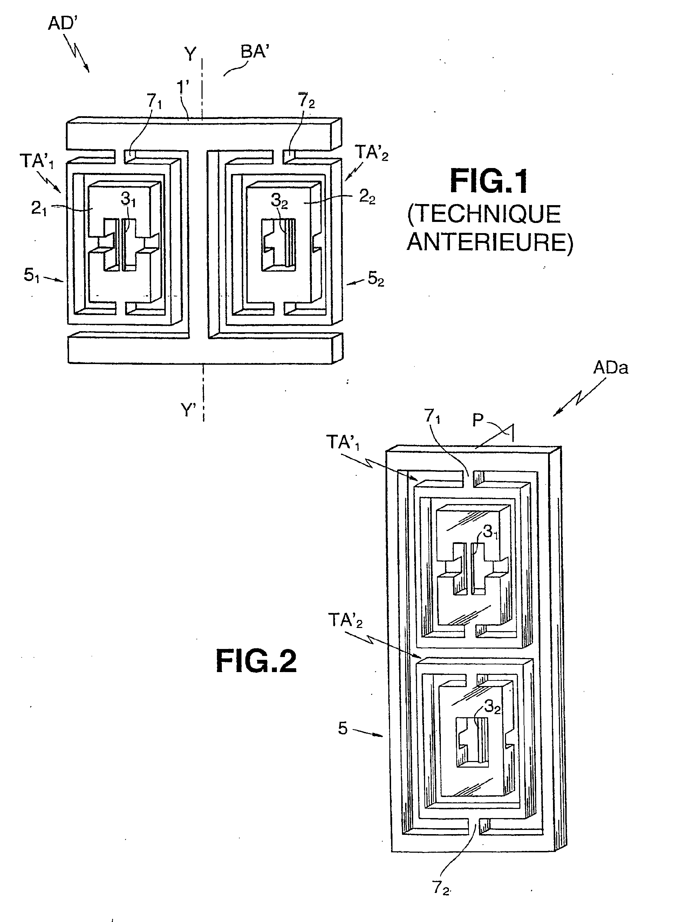

Selon le brevet n° FR 2 739 190 au nom du demandeur, un accéléromètre vibrant différentiel monolithique AD' montré à la figure 1 comporte deux éléments vibrants $TA'_1$ et $TA'_2$ sensiblement identiques et réalisés dans la même plaque de matériau d'épaisseur uniforme. Chacun des deux éléments vibrants $TA'_1$ et $TA'_2$ est un transducteur d'accélération comportant notamment une masse d'épreuve ($2_1$, $2_2$), un résonateur ($3_1$, $3_2$) dont la fréquence de résonance varie en fonction de l'accélération appliquée suivant un axe sensiblement perpendiculaire au plan de la plaque, et un cadre flexible ($5_1$, $5_2$) relié au moyen d'un unique pont de liaison ($7_1$, $7_2$) à la branche supérieure d'une partie fixe 1'de contour de face en I. Les transducteurs $TA'_1$ et $TA'_2$ sont symétriques l'un de l'autre par rapport à l'axe central YY' de l'accéléromètre AD'.

La partie fixe 1' est destinée à être solidaire de la structure d'un véhicule (non représenté) par l'intermédiaire d'une embase de boîtier BA'. Ainsi, les variations de fréquence de chacun des deux transducteurs d'accélération $TA'_1$ et $TA'_2$ sont représentatives des variations d'accélération subies par le véhicule. Le résonateur $3_1$ affleure l'une des deux faces de la plaque et le résonateur $3_2$ affleure l'autre face, ce qui permet qu'une accélération appliquée perpendiculairement au plan de la plaque provoque une augmentation de la fréquence de résonance de l'un des deux résonateurs et une diminution, de valeur sensiblement identique, de la fréquence de résonance de l'autre résonateur.

Par ailleurs, l'accéléromètre est généralement soumis à l'influence d'autres grandeurs d'entrée que l'accélération à mesurer. Lorsque ces autres grandeurs d'entrée, dites parasites, agissent en mode commun sur les deux transducteurs, ce qui est le cas par exemple de variations de température, elles provoquent des variations de fréquence sensiblement identiques sur les deux résonateurs. La grandeur de sortie de l'accéléromètre AD' étant la différence des deux fréquences, on voit qu'ainsi l'influence de ces grandeurs d'entrée parasites peut être notablement réduite, et que la sensibilité de l'accéléromètre est sensiblement le double de la sensibilité de chacun des deux transducteurs.

Chacun des cadres flexibles ($5_1$, $5_2$) a pour fonction de réaliser un filtre mécanique entre le résonateur ($3_1$, $3_2$) et la partie fixe 1', et peut être considéré de façon simplifiée comme étant une suspension filtrante dont la fréquence de résonance est nettement inférieure à celle du résonateur. Par analogie électrique, ce type de filtrage correspond à un filtre passe-bas du deuxième ordre. La partie fixe 1' est ainsi très peu sollicitée par les vibrations du résonateur dont le coefficient de surtension n'est donc pratiquement pas altéré.

La conception mécanique de l'accéléromètre connu AD' présente des inconvénients, particulièrement au sujet du couplage mécanique entre les vibrations des deux résonateurs lorsque les fréquences des deux vibrations sont proches l'une de l'autre. C'est le cas notamment lorsque, cherchant à réaliser un accéléromètre de grande précision, on vise à obtenir deux transducteurs $TA'_1$ et $TA'_2$ les plus identiques possible afin de bénéficier de l'effet différentiel maximal. Il en résulte que les deux fréquences sont amenées à se croiser pour une valeur d'accélération contenue dans l'étendue de mesure de l'accéléromètre. A l'approche du croisement des fréquences apparaît alors un phénomène de couplage mécanique qui se traduit dans un premier temps par une augmentation du bruit de mesure, puis par une identité parfaite des deux fréquences pour des valeurs d'accélération situées dans une petite zone appelée « zone aveugle de mesure ». Dans cette petite zone, les deux fréquences sont « verrouillées » l'une à l'autre, ce qui empêche la mesure de l'accélération. A titre indicatif, pour un accéléromètre connu AD' dimensionné pour mesurer jusqu'à 100 g et dont la précision, pour un éloignement suffisant des deux fréquences, est typiquement de l'ordre de $10^{-4}$ g, la zone aveugle peut atteindre 1 g, ce qui correspond à une dégradation par un facteur 10 000 de la précision de mesure d'une accélération contenue dans cette zone.

Cette dégradation très importante de la précision est due essentiellement à trois causes : le caractère monolithique de l'accéléromètre AD', la quasi-absence d'amortissement des matériaux généralement utilisés pour réaliser des capteurs de grande précision, par exemple du quartz ou du silicium, et le fait que les deux ponts de liaison $7_1$ et $7_2$ sont directement reliés entre eux par la branche supérieure de la partie fixe 1'. Ainsi, malgré le filtrage mécanique procuré par les cadres flexibles $5_1$ et $5_2$ qui permet que la partie fixe 1' soit très peu sollicitée par les vibrations des résonateurs $3_1$ et $3_2$, la très faible sollicitation provenant de chacun des éléments vibrants est directement transmise à l'autre élément vibrant. Ainsi, lorsque les deux fréquences sont proches l'une de l'autre, l'effet de cette très faible sollicitation est amplifié par un facteur voisin du coefficient de surtension du résonateur dudit autre élément vibrant, ce qui provoque le couplage mécanique entre les deux résonateurs.

Comme le caractère monolithique et la nature des matériaux utilisés pour ces capteurs ne sauraient être modifiés, compte tenu des avantages déjà cités, seule la voie d'un perfectionnement de la conception mécanique du dispositif de maintien des deux éléments vibrants reste possible.

Ainsi, dans cette voie, afin de résoudre le problème du couplage mécanique entre les deux résonateurs, il pourrait paraître intéressant de s'inspirer de la fonction de filtrage mécanique procurée par un cadre flexible du type de ceux ($5_1$, $5_2$) montrés à la figure 1 pour réaliser un filtre mécanique entre les deux ponts de liaison $7_1$ et $7_2$, ainsi qu'illustré à la figure 2 où lesdits ponts de liaison sont solidaires d'un cadre flexible 5 entourant les deux transducteurs d'accélération $TA'_1$ et $TA'_2$. On obtiendrait ainsi l'accéléromètre vibrant différentiel monolithique ADa tel que représenté à la figure 2 et pour lequel, afin d'obtenir l'efficacité maximale du filtrage procuré par le cadre flexible 5 et conformément aux recommandations mentionnées dans le brevet déjà cité, le plan P perpendiculaire au plan du cadre 5 et passant par les deux ponts de liaison $7_1$ et $7_2$ est un plan de symétrie de l'accéléromètre ADa. Toutefois, la forme et la disposition du cadre flexible 5 représenté à la figure 2 ne pourraient convenir de façon satisfaisante à un accéléromètre vibrant différentiel monolithique car le couplage mécanique entre les deux résonateurs $3_1$ et $3_2$ ne serait pas suffisamment réduit. A titre indicatif, pour un accéléromètre ADa dimensionné pour mesurer jusqu'à 100 g et dont la précision, pour un éloignement suffisant des deux fréquences, est typiquement de l'ordre de $10^{-4}$ g, la zone aveugle de mesure ne peut être inférieure à 0,1 g à moins d'augmenter dans de trop grandes proportions la souplesse du cadre flexible 5 et ainsi diminuer de façon rédhibitoire la fréquence propre la plus basse et donc la robustesse de l'accéléromètre. Ce résultat, bien qu'en progrès sensible par rapport à la zone aveugle d'environ 1 g de l'accéléromètre AD' de la figure 1, est donc encore très loin de permettre d'obtenir la précision de $10^{-4}$ g dans toute l'étendue de mesure de l'accéléromètre, et le lecteur aura compris que la fonction de filtrage mécanique procurée par le cadre flexible 5 travaillant en suspension filtrante ne convient pas pour réduire suffisamment le couplage mécanique entre les deux résonateurs et donc la zone aveugle de mesure.

La présente invention vise à remédier à cet inconvénient de l'accéléromètre connu illustré à la figure 1 et de l'accéléromètre inspiré du brevet déjà cité et illustré à la figure 2, en proposant une forme géométrique de dispositif de découplage intégré à la structure monolithique du capteur vibrant différentiel et permettant d'éviter le couplage mécanique entre les vibrations des deux éléments vibrants lorsque les fréquences des deux vibrations sont proches l'une de l'autre. Il doit être entendu que la portée de l'invention n'est pas limitée aux accéléromètres et qu'elle s'étend plus généralement aux capteurs mettant en oeuvre deux éléments vibrants travaillant constamment ou occasionnellement à des fréquences très voisines, c'est-à-dire pour lesquelles l'écart relatif de fréquence est inférieur à 0,1% dans la pratique. Dans ce cas de proximité des deux fréquences et afin de rendre plus claire la présentation de certains aspects de l'invention, on désignera lesdites fréquences par « fréquence de travail commune » des deux éléments vibrants.

Selon l'invention, le capteur usiné dans une plaque plane comportant deux éléments vibrants sensiblement identiques fonctionnant en mode différentiel avec une fréquence de travail commune et reliés entre eux par un dispositif mécanique, symétrique par rapport à un axe perpendiculaire à la plaque, constitué d'un cadre et de deux ponts de liaison supportant chacun un élément, caractérisé en ce que le cadre est constitué d'une succession de parties massives et de parties amincies en ce que les deux parties amincies situées respectivement de part et d'autre de chacun des deux ponts de liaison et les plus proches dudit pont de liaison ont des souplesses mécaniques très différentes l'une de l'autre, et en ce que les masses des parties massives et les raideurs des parties amincies sont ajustées de telle sorte que la fréquence d'un mode de résonance structurelle du cadre est sensiblement égale à la fréquence de travail commune, et que chaque pont de liaison est disposé dans un noeud de vibration du cadre à la fréquence de travail commune, et que le dispositif mécanique n'a pas de plan de symétrie passant par l'axe perpendiculaire.

Ainsi, à la fréquence de travail commune, ce sont les vibrations du cadre en réponse aux sollicitations de chacun des éléments vibrants qui s'adaptent spontanément pour empêcher les deux ponts de liaison de vibrer, ce qui permet d'obtenir que le comportement vibratoire d'un élément vibrant soit sensiblement le même que s'il était supporté par un moyen indépendant de celui de l'autre élément vibrant. Ainsi, comme il n'y a pratiquement plus de couplage mécanique entre les vibrations issues des éléments, la précision de la mesure fournie par le capteur différentiel est améliorée.

Afin que le bon fonctionnement du dispositif s'accommode de tolérances de fabrication relativement larges, les deux parties amincies situées respectivement de part et d'autre de chacun des deux ponts de liaison et les plus proches dudit pont de liaison ont des souplesses mécaniques très différentes l'une de l'autre.

Pour réaliser un capteur compact, les éléments vibrants sont situés à l'intérieur du cadre.

D'autres caractéristiques et avantages de l'invention apparaîtront plus clairement à la lecture de la description détaillée et des figures qui s'y rapportent dans lesquelles :

- la figure 1 est une vue en perspective d'un accéléromètre vibrant différentiel monolithique appartenant à l'art antérieur et déjà commenté ;

- la figure 2 est une vue en perspective d'un accéléromètre vibrant différentiel monolithique inspiré de l'art antérieur et déjà commenté ;
- la figure 3 est une vue en perspective d'un accéléromètre vibrant différentiel monolithique intégrant un dispositif de découplage mécanique selon une première réalisation de l'invention ;
- la figure 4 représente un modèle théorique simplifié constitué de masses et de ressorts, destiné à expliquer le fonctionnement du dispositif de découplage mécanique de la figure 3 ;
- la figure 5 est une vue en perspective d'une autre réalisation d'un dispositif de découplage mécanique conforme à l'invention.

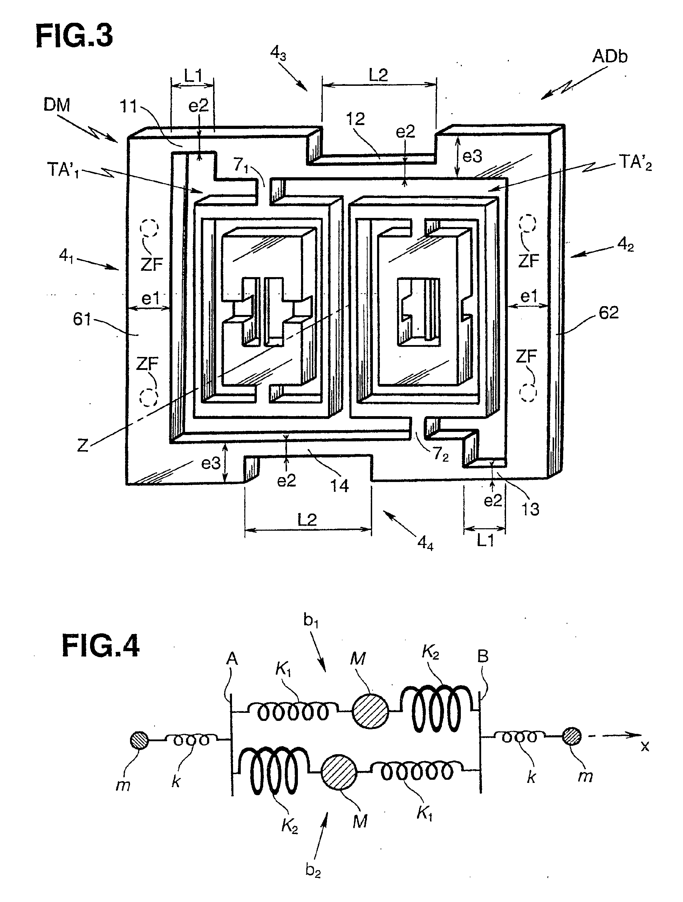

En référence à la figure 3, un dispositif de découplage mécanique selon l'invention relie deux éléments vibrants $TA'_1$ et $TA'_2$ sensiblement identiques. Le dispositif est sous la forme d'un cadre DM entourant les deux éléments vibrants et de deux ponts de liaison ($7_1$, $7_2$) supportant chacun un élément vibrant. Le cadre DM, les deux éléments vibrants $TA'_1$ et $TA'_2$ et les deux ponts de liaison $7_1$ et $7_2$ forment un corps monolithique d'accéléromètre vibrant différentiel ADb. Le cadre DM et les deux ponts de liaison $7_1$ et $7_2$ forment une structure plane qui a pour axe de symétrie l'axe central Z perpendiculaire aux grandes faces de ladite structure. Ladite structure n'a pas de plan de symétrie contenant l'axe central Z.

Le corps monolithique d'accéléromètre ADb peut être réalisé en une seule étape d'usinage chimique d'une plaque plane de matériau, par exemple du quartz ou du silicium, de même qu'expliqué dans le brevet déjà cité pour l'accéléromètre AD' montré à la figure 1. Concernant les structures réalisées dans la présente invention, l'usinage chimique ne permet pas une maîtrise rigoureuse des formes des différents éléments constitutifs. L'homme de l'art comprendra que cette imprécision doit être prise en compte dans l'interprétation de certains termes descriptifs, comme par exemple les épaisseurs des éléments ou la symétrie de la structure.

Le cadre DM, de forme générale rectangulaire, est constitué de quatre cotés $4_1$, $4_2$, $4_3$ et $4_4$. Les cotés $4_3$ et $4_4$ sont disposés en regard l'un de l'autre et sont chacun solidaires d'un pont de liaison ($7_1$, $7_2$). Les cotés $4_1$ et $4_2$ ont une dimension de section e1 prise dans le plan du cadre DM. La dimension de section n'est pas constante le long des deux autres cotés $4_3$ et $4_4$ dans lesquels il a été pratiqué des enlèvements de matière afin d'obtenir des parties amincies (11, 12, 13, 14) dont la dimension de section e2 est nettement inférieure à la dimension de section e3 des parties non amincies desdits cotés. Selon la représentation illustrée, la dimension e2 est égale sensiblement au tiers de la dimension e3. Généralement, la dimension e2 est comprise entre le quart et la moitié de la dimension e3. Chacun des cotés $4_3$ et $4_4$ comporte une partie amincie (11, 13) située d'un côté du pont de liaison qui lui est solidaire ($7_1$, $7_2$) et de

dimension de longueur L1, et une partie amincie (12, 14) située de l'autre côté dudit pont de liaison et de dimension de longueur L2 nettement supérieure à L1. Selon la représentation illustrée, la dimension L2 est égale sensiblement à trois fois la dimension L1. Généralement, la dimension L2 est comprise entre deux fois et dix fois la dimension L1. Ainsi, les parties amincies 12 et 14 de dimension de longueur L2 sont nettement plus souples que les parties amincies 11 et 13 de dimension de longueur L1. Il doit être entendu que cette différence de souplesse, qui constitue une caractéristique du dispositif selon l'invention, peut être obtenue autrement que par la seule différence de longueur entre L1 et L2. Ainsi, la dimension de section des parties amincies 11 et 13 peut être différente de la dimension de section des parties amincies 12 et 14.

Toujours selon la représentation illustrée à la figure 3, chacun des cotés $4_1$ et $4_2$ de dimension de section e1 est solidaire d'une partie non amincie de dimension de section e3 de l'un des deux autres cotés $4_4$ et $4_3$, et forme avec ladite partie non amincie une partie massive (61, 62).

Ainsi, le cadre DM peut être vu comme constitué essentiellement d'une succession de deux parties massives (61, 62) et de quatre parties amincies (11, 12, 13 14) disposées de telle sorte que chacune desdites parties massives est reliée à chacun des deux ponts de liaison par l'intermédiaire d'une partie amincie.

L'accéléromètre ADb est fixé, par exemple par collage, sur une embase de boîtier (non représentée) aux niveaux des quatre petites zones circulaires ZF situées sur l'une des faces du cadre DM aux niveaux des parties massives 61 et 62, et représentées en pointillé à la figure 3. Il est important de souligner que ces quatre petites zones de fixation ZF permettent que la tenue de l'accéléromètre ADb soit suffisamment rigide dans la bande passante de mesure, typiquement de l'ordre de 1000 Hz, et suffisamment souple pour ne pas s'opposer à l'existence d'un mode de résonance structurelle du cadre DM à une fréquence voisine de la fréquence de travail commune des deux éléments vibrants, typiquement de l'ordre de 50 000 Hz, ce qui ne pourrait pas être obtenu si la totalité de la face du cadre DM était fixée sur l'embase de boîtier.

Le cadre DM est dimensionné pour qu'il existe un mode de résonance structurelle à la fréquence de travail commune tel que au niveau de chacun des ponts de liaison $7_1$ et $7_2$ se trouvent des noeuds de résonance structurelle du cadre. Ce dimensionnement peut être déterminé au moyen d'un modèle théorique du comportement vibratoire du cadre, comme par exemple un modèle tridimensionnel aux éléments finis. De préférence, l'écart relatif entre la fréquence de ladite résonance structurelle du cadre et la fréquence de travail commune des deux éléments vibrants est inférieur à 5%.

Le fonctionnement du dispositif de découplage mécanique selon l'invention est maintenant présenté en référence à la figure 4 qui montre un modèle théorique simplifié à un seul axe x de vibration et constitué de masses et de ressorts permettant de simuler le comportement mécanique vibratoire de l'accéléromètre ADb de la figure 3. La description de la figure 4 est donc effectuée en relation avec la figure 3.

Les deux ensembles constitués chacun d'une masse $m$ et d'une raideur $k$ représentent les deux éléments vibrants $TA'_1$ et $TA'_2$ dont la fréquence de travail commune $F_0$ s'écrit :

$$F_0 = \frac{1}{2\pi}\sqrt{\frac{k}{m}}$$

Chacun desdits ensembles est solidaire au niveau (A, B) sur l'axe x de deux branches $b_1$ et $b_2$ constituées chacune d'une masse $M$ et de deux raideurs $K_1$ et $K_2$. Les niveaux A et B représentent les ponts de liaison $7_1$ et $7_2$ respectivement, et les branches $b_1$ et $b_2$ représentent le cadre DM pour lequel les parties massives 61 et 62 sont représentées par les deux masses $M,$ les parties amincies 12 et 14 sont représentées par les deux raideurs $K_1$, et les parties amincies 11 et 13 sont représentées par les deux raideurs $K_2$ de valeur nettement supérieure à $K_1$.

Le modèle masses-ressorts de la figure 4 représente convenablement certains aspects importants de la configuration mécanique de la structure formée par le cadre DM et les deux ponts de liaison $7_1$ et $7_2$, notamment en ce qui concerne la différence de souplesse entre les parties amincies 12, 14 et les parties amincies 11, 13, en ce qui concerne le fait que chacune des parties massives est reliée à chacun des deux ponts de liaison par l'intermédiaire d'une partie amincie, et en ce qui concerne la symétrie par rapport à l'axe central Z et l'absence de symétrie par rapport à un plan contenant ledit axe.

Afin que les deux branches $b_1$ et $b_2$ du modèle masses-ressorts de la figure 4 permettent de simuler le comportement mécanique du cadre DM selon l'invention, il faut de plus que les masses $M$ et les raideurs $K_1$ et $K_2$ soient ajustées pour que la fréquence $F_b$ de résonance des branches $b_1$ et $b_2$, considérée avec des conditions d'encastrement aux niveaux A et B, soit égale à la fréquence de travail commune $F_0$ :

$$F_b = \frac{1}{2\pi}\sqrt{\frac{(K_1 + K_2)}{M}} = F_0$$

Dans ces conditions d'ajustement, les équations classiques traduisant l'équilibre dynamique des masses $m$ et $M$ permettent de montrer que, dans la simulation du cas réel où les niveaux A et B sont libres de se déplacer, la vibration de l'un quelconque des deux ensembles constitués chacun d'une masse $m$ et d'une raideur $k$ provoque des vibrations des branches $b_1$ et $b_2$

qui s'adaptent spontanément pour maintenir immobiles les niveaux A et B. Ainsi, chacun desdits ensembles vibre comme s'il était encastré au niveau (A, B). Ainsi, les vibrations desdits ensembles sont indépendantes l'une de l'autre et il n'y a donc pas de couplage mécanique entre lesdites vibrations. Les équations classiques de l'équilibre dynamique des masses $m$ et $M$ permettent de plus de montrer que cette absence de couplage mécanique entre lesdites vibrations ne peut être obtenue que si les raideurs $K_1$ et $K_2$ sont différentes l'une de l'autre, ce qui traduit la nécessité, pour la structure formée par le cadre DM et les deux ponts de liaison $7_1$ et $7_2$, de l'absence de symétrie par rapport à un plan contenant l'axe central Z. De même, ladite absence de couplage mécanique ne peut être obtenue que si chaque ensemble constitué d'une masse $m$ et d'une raideur $k$ est solidaire à un seul niveau (A, B) des deux branches $b_1$ et $b_2$, ce qui explique pourquoi chacun des deux éléments vibrants doit être relié au dispositif de découplage mécanique selon l'invention par l'intermédiaire d'un unique pont de liaison.

Par analogie électrique, il est possible de voir le fonctionnement du dispositif selon l'invention comme celui d'un circuit bouchon accordé pour éliminer un signal électrique à une fréquence particulière.

Grâce à son principe de fonctionnement, l'efficacité du dispositif de découplage mécanique selon l'invention peut s'accommoder d'une fréquence propre élevée pour l'accéléromètre ADb, contrairement à l'accéléromètre ADa de la figure 2 inspiré de l'art antérieur pour lequel l'efficacité du filtrage mécanique procuré par le cadre 5 est d'autant plus grande que la fréquence propre dudit cadre est plus basse, ainsi qu'expliqué antérieurement par l'analogie électrique du filtre passe-bas du deuxième ordre.

Ainsi, il est possible de réaliser un accéléromètre ADb comportant un dispositif de découplage mécanique selon l'invention, dimensionné pour mesurer jusqu'à 100 g, dont la zone aveugle est inférieure à $10^{-4}$ g et dont la fréquence propre la plus basse vaut 3000 Hz, valeur suffisamment élevée pour assurer une robustesse suffisante de l'accéléromètre dans beaucoup d'applications.

Le modèle théorique simplifié illustré à la figure 4 permet également de tirer un autre enseignement pouvant s'appliquer au dispositif de découplage mécanique selon l'invention et concernant les tolérances de fabrication dudit dispositif. Dans la pratique, il est souhaitable que le coût de fabrication du capteur différentiel incluant le dispositif de découplage mécanique selon l'invention ne soit pas grevé d'un surcoût lié à une difficulté de réaliser ledit dispositif avec une précision géométrique suffisante pour obtenir l'efficacité désirée. Les équations classiques traduisant l'équilibre dynamique des masses $m$ et $M$ du modèle théorique de la figure 4 permettent de montrer que les tolérances de réalisation du dispositif selon l'invention sont proportionnelles à

$$\frac{(K_1 - K_2)^2}{K_1 K_2}$$ . Ainsi, on en déduit que lesdites tolérances de réalisation sont d'autant plus larges que les raideurs $K_1$ et $K_2$ sont différentes l'une de l'autre. C'est pourquoi, dans le cas du dispositif de découplage mécanique montré à la figure 3, les parties amincies 12 et 14 sont nettement plus souples que les parties amincies 11 et 13. Dans la pratique, cela permet que les tolérances de réalisation dudit dispositif soient de l'ordre de quelques µm, ce qui est compatible avec la précision des procédés classiquement mis en oeuvre pour l'usinage chimique de capteurs de petites dimensions.

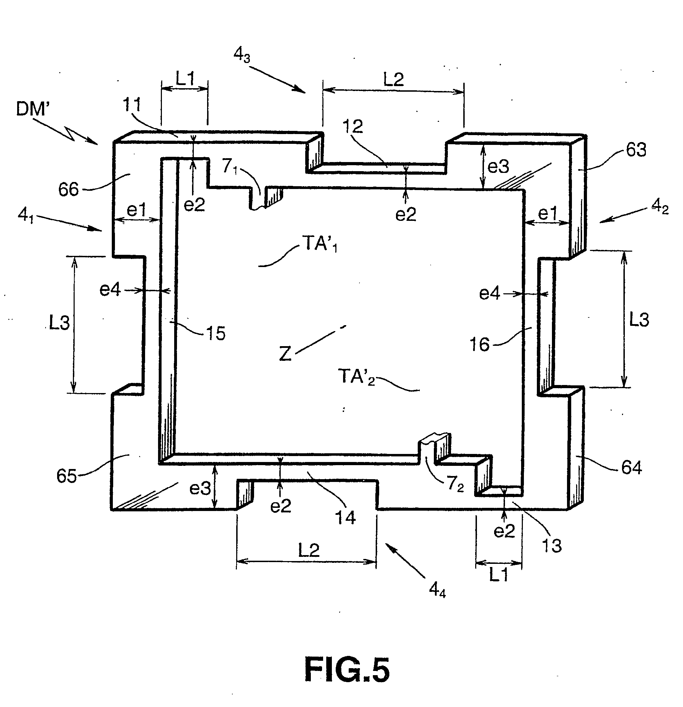

La figure 5 montre une autre réalisation d'un dispositif de découplage mécanique selon l'invention. De même que le dispositif représenté à la figure 3, le dispositif de la figure 5 est sous la forme générale d'un cadre rectangulaire DM' constitué de quatre cotés $4_1$, $4_2$, $4_3$ et $4_4$ et qui diffère du cadre DM de la figure 3 principalement par un plus grand nombre de parties massives et de parties amincies. Plus précisément, des enlèvements de matière ont été pratiqués dans les cotés $4_1$ et $4_2$ afin d'obtenir les parties amincies 15 et 16 dont la dimension de section e4 prise dans le plan du cadre DM' est nettement inférieure à la dimension de section e1 des parties non amincies desdits cotés. Selon la représentation illustrée, la dimension e4 est égale sensiblement au tiers de la dimension e1. Généralement, la dimension e4 est comprise entre le quart et la moitié de la dimension e1. Toujours selon la représentation illustrée, la dimension de longueur L3 des parties amincies 15 et 16 est sensiblement égale à la dimension de longueur L2 des parties amincies 12 et 14 des deux autres cotés $4_3$ et $4_4$. Généralement, L3 est compris entre la moitié et le double de L2.

Toujours selon la représentation illustrée à la figure 5, une partie non amincie de chacun des cotés $4_1$ et $4_2$ est solidaire d'une partie non amincie de l'un des deux autres cotés $4_4$ et $4_3$ et forme avec ladite partie non amincie une partie massive (65, 63), l'autre partie non amincie de chacun des cotés $4_1$ et $4_2$ formant à elle seule une partie massive (66, 64).

Ainsi, le cadre DM' peut être vu comme constitué essentiellement d'une succession de quatre parties massives (63, 64, 65, 66) et de six parties amincies (11, 12, 13, 14, 15, 16).

L'étude théorique du comportement vibratoire du cadre DM', effectuée par exemple au moyen d'un modèle théorique simplifié à un seul axe de vibration et constitué de quatre masses et de six ressorts, permet de montrer que le plus grand nombre de parties massives et de parties amincies permet, par rapport au cadre DM représenté à la figure 3, d'élargir sensiblement les tolérances de réalisation nécessaires au bon fonctionnement du dispositif, à condition toutefois que, comme pour le cadre DM, les deux parties amincies (11 et 12, 13 et 14) situées respectivement de part et d'autre de chacun des deux

ponts de liaison ($7_1$, $7_2$) et les plus proches dudit pont de liaison aient des souplesses mécaniques très différentes l'une de l'autre. Il faut toutefois noter que, s'il pourrait paraître intéressant au vu de l'étude de modèles masses-ressorts de multiplier encore le nombre de parties massives et de parties amincies, il en est autrement dans la réalité où cela conduirait à obtenir un dispositif dans lequel la dissociation entre lesdites parties serait moins nette que dans les cas des cadres DM et DM', ledit dispositif ne permettant pas de procurer d'amélioration sensible par rapport aux cadres DM et DM'. Dans la pratique, les cadres DM et DM' permettent des réalisations efficaces de dispositifs de découplage mécanique selon l'invention, les tolérances de réalisation plus larges du cadre DM' permettant de le fabriquer avec des procédés plus simples et donc moins coûteux à mettre en oeuvre que pour le cadre DM.

**Revendications**

1.   Capteur usiné dans une plaque plane comportant deux éléments vibrants (TA'$_1$, TA'$_2$) sensiblement identiques fonctionnant en mode différentiel avec une fréquence de travail commune et reliés entre eux par un dispositif mécanique, symétrique par rapport à un axe perpendiculaire à la plaque, constitué d'un cadre (DM) et de deux ponts de liaison ($7_1$, $7_2$) supportant chacun un élément, **caractérisé en ce que** le cadre (DM) est constitué d'une succession de parties massives (61 et 62) et de parties amincies (11 et 12, 13 et 14), **en ce que** les deux parties amincies (11 et 12, 13 et 14) situées respectivement de part et d'autre de chacun des deux ponts de liaison ($7_1$, $7_2$) et les plus proches dudit pont de liaison ont des souplesses mécaniques très différentes l'une de l'autre, et **en ce que** les masses (M) des parties massives (61, 62) et les raideurs (K1, K2) des parties amincies (11 et 12, 13 et 14) sont ajustées de telle sorte que la fréquence d'un mode de résonance structurelle du cadre (DM) est sensiblement égale à la fréquence de travail commune, et que chaque pont de liaison ($7_1$, $7_2$) est disposé dans un noeud de vibration du cadre à la fréquence de travail commune, et que le dispositif mécanique n'a pas de plan de symétrie passant par l'axe perpendiculaire.

2.   Capteur selon la revendication 1, **caractérisé en ce que** le cadre (DM') entoure les deux éléments vibrants (TA'$_1$, TA'$_2$).

3.   Capteur selon les revendications 1 ou 2, **caractérisé en ce que** le cadre (DM') est constitué de quatre cotés ($4_1$, $4_2$, $4_3$, $4_4$) disposés suivant la forme générale d'un rectangle, deux ($4_3$, $4_4$) desdits cotés disposés en regard l'un de l'autre et solidaires chacun d'un pont de liaison ($7_1$, $7_2$) ayant chacun deux parties amincies (11 et 12, 13 et 14) situées respectivement de part et d'autre de chacun des deux ponts de liaison.

4. Capteur selon la revendication 3, **caractérisé en ce que** les parties amincies (11, 12, 13, 14) des deux cotés ($4_3$, $4_4$) solidaires chacun d'un pont de liaison ($7_1$, $7_2$) ont une dimension de section (e2) prise dans le plan du cadre (DM') comprise entre le quart et la moitié de la dimension de section (e3) des parties non amincies desdits cotés.

5. Capteur selon la revendication 4, **caractérisé en ce que** les deux parties amincies (11 et 12, 13 et 14) situées respectivement de part et d'autre de chacun des deux ponts de liaison ($7_1$, $7_2$) et les plus proches dudit pont de liaison ont des dimensions de longueur (L1, L2) très différentes l'une de l'autre, la plus grande (L2) desdites dimensions de longueur étant comprise entre deux fois et dix fois l'autre (L1) dimension de longueur.

6. Capteur selon la revendication 5, **caractérisé en ce que** les deux autres cotés ($4_1$, $4_2$) ont chacun une partie amincie (15, 16) dont la dimension de section (e4) prise dans le plan du cadre (DM') est comprise entre le quart et la moitié de la dimension de section (e1) des parties non amincies desdits autres cotés.

7. Capteur selon la revendication 6, **caractérisé en ce que** la dimension de longueur (L3) des parties amincies (15, 16) des deux autres cotés ($4_1$, $4_2$) est comprise entre la moitié et le double de la dimension de longueur (L2) de la plus longue (12, 14) des deux parties amincies situées respectivement de part et d'autre de chacun des deux ponts de liaison ($7_1$, $7_2$) et les plus proches dudit pont de liaison.

**Patentansprüche**

1. Sensor, der aus einer ebenen Platte herausgearbeitet ist, der zwei im Wesentlichen identische Schwingelemente (TA'$_1$, TA'$_2$) aufweist, die im Differentialtakt mit einer gemeinsamen Arbeitsfrequenz arbeiten und durch eine mechanische Vorrichtung miteinander verbunden sind, die relativ zu einer zu der Platte senkrechten Achse symmetrisch ist, der von einem Rahmen (DM) und zwei Verbindungsbrücken ($7_1$, $7_2$) gebildet ist, die jede ein Element tragen, **dadurch gekennzeichnet, dass** der Rahmen (DM) aus einer Abfolge von massiven Teilen (61 und 62) und von dünnen Teilen (11 und 12, 13 und 14) besteht, dass die zwei dünnen Teile (11 und 12, 13 und 14), die auf der einen beziehungsweise auf der anderen Seite jeder der zwei Verbindungsbrücken ($7_1$, $7_2$) und der Verbindungsbrücke am nächsten angeordnet sind, mechanische Flexibilitäten aufweisen, die voneinander sehr verschieden sind, und dass die Massen (M) der massiven Teile (61, 62) und die Steifigkeiten (K1, K2) der dünnen Teile (11 und 12, 13 und 14) derart angepasst sind, dass die Frequenz eines strukturellen Resonanztakts des Rahmens (DM) im Wesentlichen gleich der gemeinsamen Arbeitsfrequenz ist und dass jede Verbindungsbrücke ($7_1$, $7_2$) in einem Schwingungsknoten des Rahmens bei der gemeinsamen Arbeitsfrequenz angeordnet ist und dass die mechanische Vorrichtung keine Symmetrieebene hat, die durch die senkrechte Achse verläuft.

2. Sensor nach Anspruch 1, **dadurch gekennzeichnet, dass** der Rahmen (DM') die zwei Schwingelemente (TA'$_1$, TA'$_2$) umgibt.

3. Sensor nach den Ansprüchen 1 oder 2, **dadurch gekennzeichnet, dass** der Rahmen (DM') aus vier Seiten ($4_1$, $4_2$, $4_3$, $4_4$) besteht, die in der allgemeinen Form eines Rechtecks angeordnet sind, wobei zwei ($4_3$, $4_4$) der Seiten, die einander gegenüber angeordnet sind und jede mit einer Verbindungsbrücke ($7_1$, $7_2$) fest verbunden sind, jede zwei dünne Teile (11 und 12, 13 und 14) aufweisen, die auf der einen bzw. auf der anderen Seite jeder der zwei Verbindungsbrücken angeordnet sind.

4. Sensor nach Anspruch 3, **dadurch gekennzeichnet, dass** die dünnen Teile (11, 12, 13, 14) der zwei Seiten ($4_3$, $4_4$), die jede mit einer Verbindungsbrücke ($7_1$, $7_2$) fest verbunden sind, ein Querschnittsmaß (e2), das in der Ebene des Rahmens (DM') genommen ist, aufweisen, das zwischen einem Viertel und der Hälfte des Querschnittsmaßes (e3) der sich nicht verjüngenden Teile der Seiten beträgt.

5. Sensor nach Anspruch 4, **dadurch gekennzeichnet, dass** die zwei dünnen Teile (11 und 12, 13 und 14), die auf der einen beziehungsweise auf der anderen Seite jeder der zwei Verbindungsbrücken ($7_1$, $7_2$) und der Verbindungsbrücke am nächsten angeordnet sind, Längenmaße (L1, L2) aufweisen, die voneinander sehr verschieden sind, wobei das größte (L2) der Längenmaße zwischen dem Zweifachen und dem Zehnfachen des anderen (L1) Längenmaßes beträgt.

6. Sensor nach Anspruch 5, **dadurch gekennzeichnet, dass** die zwei anderen Seiten ($4_1$, $4_2$) jede einen dünnen Teil (15, 16) aufweisen, dessen Querschnittsmaß (e4), das in der Ebene des Rahmens (DM') genommen ist, zwischen einem Viertel und der Hälfte des Querschnittsmaßes (e1) der nicht dünnen Teile der anderen Seiten beträgt.

7. Sensor nach Anspruch 6, **dadurch gekennzeichnet, dass** das Längenmaß (L3) der dünnen Teile (15, 16) der zwei anderen Seiten ($4_1$, $4_2$) zwischen

der Hälfte und dem Doppelten des längsten (12, 14) Längenmaßes (L2) der zwei dünnen Teile beträgt, die auf der einen beziehungsweise auf der anderen Seite jeder der zwei Verbindungsbrücken (7₁, 7₂) und der Verbindungsbrükke am nächsten angeordnet sind.

## Claims

1. A sensor machined in a plane plate including two substantially identical vibrating members (TA'₁, TA'₂) operating in differential mode with a common working frequency and joined to each other by a mechanical device, symmetrical about an axis perpendicular to the plate, comprising a frame (DM) and two connecting bridges (7₁, 7₂) each supporting one member, **characterized in that** the frame (DM) comprises a succession of mass portions (61, 62) and thinned portions (11 and 12, 13 and 14), **in that** the two thinned portions (11 and 12, 13 and 14) on respective opposite sides of each of the two connecting bridges (7₁, 7₂) and closest to said connecting bridge have very different mechanical flexibilities from each other and **in that** the masses (M) of the mass portions (61,62) and the stiffnesses (K1,K2) of the thinned portions (11 and 12, 13 and 14) are adjusted so that the frequency of one mode of structural resonance of the frame (DM) is substantially equal to the common working frequency, and each connecting bridge (7₁, 7₂) is disposed in a node of vibration of the frame at the common working frequency, and the mechanical device has no plane of symmetry passing through the perpendicular axis.

2. A sensor according to claim 1, **characterized in that** the frame (DM') surrounds the two vibrating members (TA'₁, TA'₂).

3. A sensor according to one of claims 1 and 2, **characterized in that** the frame (DM') comprises four sides (4₁, 4₂, 4₃ , 4₄) disposed as a rectangular general shape, two (4₃, 4₄) of said sides disposed facing each other and each fastened to a connecting bridge (7₁, 7₂) each having two thinned portions (11 and 12, 13 and 14) on respective opposite sides of each of the two connecting bridges.

4. A sensor according to claim 3, **characterized in that** the thinned portions (11, 12, 13, 14) of the two sides (4₃, 4₄) each fastened to a connecting bridge (7₁, 7₂) have a section dimension (e2) in the plane of the frame (DM') lying between one quarter and one half of the section dimension (e3) of the non-thinned portions of said sides.

5. A sensor according to claim 4, **characterized in that** the two thinned portions (11 and 12, 13 and 14) on respective opposite sides of each of the two connecting bridges (7₁, 7₂) and closest to said connecting bridge have length dimensions (L1, L2) very different therebetween, the greater of said length dimensions (L2) lying between twice times and ten times the other length dimension (L1).

6. A sensor according to claim 5, **characterized in that** the two other sides (4₁, 4₂) each have a thinned portion (15, 16), the section dimension (e4) of which in the plane of the frame (DM') lies between one quarter and one half of the section dimension (e1) of the non-thinned portions of said other sides.

7. A sensor according to claim 6, **characterized in that** the length dimension (L3) of the thinned portions (15, 16) of the two other sides (4₁, 4₂) lies between one half and twice of the length dimension (L2) of the longest (12, 14) of the two thinned portions (7₁, 7₂) on respective opposite sides of each of the two connecting bridges and closest to said connecting bridge.

**FIG.1**
(TECHNIQUE
ANTERIEURE)

**FIG.2**

# FIG.3

# FIG.4

**FIG.5**

**RÉFÉRENCES CITÉES DANS LA DESCRIPTION**

**Documents brevets cités dans la description**

- US 4216402 A
- FR 2739190